(19) **Europäisches Patentamt / European Patent Office / Office européen des brevets**

(11) **EP 4 049 088 B1**

(12) **EUROPEAN PATENT SPECIFICATION**

(45) Date of publication and mention of the grant of the patent:
**04.10.2023 Bulletin 2023/40**

(21) Application number: **20764005.3**

(22) Date of filing: **11.08.2020**

(51) International Patent Classification (IPC):
**G03F 7/00** *(2006.01)*   **G03F 7/20** *(2006.01)*
**G01N 17/00** *(2006.01)*   **G01N 27/02** *(2006.01)*
**G02B 7/22** *(2021.01)*   **G02B 7/195** *(2021.01)*
**G02B 27/18** *(2006.01)*   **G01R 27/22** *(2006.01)*

(52) Cooperative Patent Classification (CPC):
**G03F 7/70983; G01N 17/00; G02B 7/195; G02B 27/18; G03F 7/70891**

(86) International application number:
**PCT/EP2020/072485**

(87) International publication number:
**WO 2021/078421 (29.04.2021 Gazette 2021/17)**

(54) **ASSEMBLY IN AN OPTICAL SYSTEM, IN PARTICULAR OF A MICROLITHOGRAPHIC PROJECTION EXPOSURE APPARATUS**

ANORDNUNG IN EINEM OPTISCHEN SYSTEM, INSBESONDERE EINEM MIKROLITHOGRAFISCHEN PROJEKTIONSBELICHTUNGSGERÄT

ENSEMBLE DANS UN SYSTÈME OPTIQUE, EN PARTICULIER D'UN APPAREIL D'EXPOSITION PAR PROJECTION MICROLITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.10.2019 DE 102019216301**

(43) Date of publication of application:
**31.08.2022 Bulletin 2022/35**

(73) Proprietor: **Carl Zeiss SMT GmbH**
**73447 Oberkochen (DE)**

(72) Inventors:
• **HARTJES, Joachim**
  **73433 Aalen (DE)**
• **GRUNER, Toralf**
  **73433 Aalen (DE)**
• **WOLF, Alexander**
  **73457 Essingen (DE)**

(74) Representative: **Frank, Hartmut**
**Bonsmann Bonsmann Frank**
**Patentanwälte**
**Reichspräsidentenstraße 21-25**
**45470 Mülheim a. d. Ruhr (DE)**

(56) References cited:
DE-A1-102017 221 388    JP-B2- 4 718 267
US-A1- 2008 163 692    US-A1- 2016 274 045

## Description

BACKGROUND OF THE INVENTION

Field of the invention

The invention relates to an assembly in an optical system, in particular of a microlithographic projection exposure apparatus.

Prior art

Microlithography is used for production of microstructured components, for example integrated circuits or LCDs. The microlithography process is conducted in what is called a projection exposure apparatus, which comprises an illumination device and a projection lens. The image of a mask (= reticle) illuminated by means of the illumination device is in this case projected by means of the projection lens onto a substrate (e.g., a silicon wafer) coated with a light-sensitive layer (photoresist) and arranged in the image plane of the projection lens, in order to transfer the mask structure to the light-sensitive coating of the substrate. In projection lenses designed for the EUV range, i.e., at wavelengths of, e.g., approximately 13 nm or approximately 7 nm, mirrors are used as optical components for the imaging process owing to the lack of availability of suitable lighttransmissive refractive materials.

One problem which arises in practice is that, in particular as a result of the absorption of the radiation emitted by the EUV light source, the EUV mirrors heat up and thus undergo an associated thermal expansion or deformation, which in turn can negatively affect the imaging properties of the optical system. This is the case in particular if illumination settings with comparatively small illumination poles are used (e.g. in dipole or quadrupole illumination settings), in which the mirror heating or deformation varies greatly over the optical effective surface of the mirror.

A transfer of solution approaches for overcoming the above-described problem of mirror heating known from VUV lithography systems (with an operating wavelength of approximately 200 nm or approximately 160 nm, for example) to EUV systems is difficult in part insofar as, inter alia, the number of optical effective surfaces available for active deformation compensation is relatively tightly delimited as a consequence of the comparatively smaller number of optical elements or mirrors (for avoiding excessively high light losses on account of the necessary reflections).

Known approaches for dissipating thermal loads from optical components particularly of a microlithographic projection exposure apparatus include, inter alia, the use of cooling channels through which a cooling fluid such as water, for example, flows in order to carry away heat and which are connected to an inlet and an outlet for the cooling fluid.

In practice, however, the further problem can arise here that, depending on the structural configuration of said cooling channels (which can extend e.g. on the mirror rear side or in a mechanical carrying structure), corrosion-dictated damage caused by the cooling fluid can occur within the cooling lines themselves and/or in the region of flange connections and then result in a limitation of the service life of the assembly. In particular, in the case where the assembly is constructed from components that are separated from one another, the cooling fluid can flow over a gap present between such components and cause corrosion-dictated leaks in the region of the flange connections. Given the occurrence of corrosion-dictated leaks, ingress of cooling liquid into the respective optical system can result in serious damage there.

Avoiding the corrosion-dictated problems described above proves to be difficult in practice because, inter alia, e.g. carrying out ultrasonic measurements for corrosion detection in an EUV system is ruled out owing to the risk of layer detachments at the optical components.

DE 10 2017 221388 A1 discloses, inter alia, a method for producing a component for a lithography system, wherein a pipe section through which a cooling fluid can flow is surrounded by a powdered filling material, and wherein the substrate of the component is produced by mechanical compression and sintering, in particular by hot isostatic pressing, of the powdered filling material. In particular, an aluminum powder which exhibits low corrosion or a ceramic powder is e.g. used as powdered filling material.

JP 4718267 B2 discloses, inter alia, inspection of the inner surface of a heat transfer pipe for corrosion on the basis of transmission of an electromagnetic signal being sent by a transmission coil and picked up by a receiver coil.

US 2016/0274045 A1 discloses, inter alia, a measuring system for determining specific electrical conductivity of a liquid medium in a vessel using an inductive conductivity sensor.

US 2008/0163692 A1 discloses, inter alia, monitoring a pipeline with respect to corrosion, wherein e.g. acoustic impedance sensors are used.

SUMMARY OF THE INVENTION

It is an object of the present invention to provide an assembly in an optical system, in particular of a microlithographic projection exposure apparatus, which makes it possible to effectively avoid corrosion-dictated problems and thus accompanying damage of the optical system.

This object is achieved by means of an assembly in accordance with the features of independent claim 1 and by means of a corresponding method for operating an optical system in accordance with the features of independent claim 13.

An assembly according to the invention in an optical system, in particular of a microlithographic projection exposure apparatus, comprises:

- at least one optical element;
- at least one cooling channel through which can flow a cooling fluid for cooling said optical element during the operation of the optical system; and
- at least one corrosion detector for detecting an existing or imminent corrosion on the basis of the determination of at least one measurement variable indicating a corrosion-dictated change in state of the cooling fluid.

The invention is based on the concept, in particular, of ascertaining incipient corrosion and initiating, at a correspondingly early stage, suitable countermeasures on the basis of a detection of corrosion-dictated changes in state of the cooling liquid situated within at least one cooling channel of the assembly.

In accordance with one embodiment, the at least one measurement variable comprises an electrical conductivity of the cooling fluid.

In accordance with one embodiment, the corrosion detector is configured for detecting an existing or imminent corrosion on the basis of a non-contact inductive conductivity measurement of the cooling fluid.

The invention thus includes, in particular, the concept of deducing incipient corrosion on the basis of a non-contact inductive conductivity measurement of the cooling fluid. This involves detecting the ionization state or electrical conductivity of the cooling fluid metrologically by a procedure in which, upon an AC voltage being applied to a transmitter coil, the electrical voltage measured at a receiver coil is compared with the transmission voltage, wherein an amplitude attenuation or phase shift ascertained during this comparison is indicative of the ionization or conductivity state of the cooling liquid.

In accordance with one embodiment, the corrosion detector is configured for detecting an existing or imminent corrosion on the basis of a magnetoinductive flow measurement. In this case, in particular upon a constant external magnetic field being applied to an insulated pipe carrying the electrically conductive cooling liquid, it is possible to measure the change in voltage that accompanies a corrosion-dictated change in the flow velocity on the basis of the Hall effect.

In accordance with one embodiment, the at least one measurement variable comprises a flow resistance of the cooling fluid.

In accordance with one embodiment, the at least one measurement variable comprises dynamic excitations or vibrations that are caused by a corrosion-dictated change in the flow state of the cooling fluid.

In accordance with one embodiment, the at least one measurement variable comprises a proportion of indicator molecules or particles present in the cooling fluid, wherein a presence of said molecules or particles in the cooling fluid indicates that they have been dissolved from a material of the assembly in a corrosion-dictated manner.

In accordance with one embodiment, the assembly has a plurality of corrosion detectors for spatially resolved corrosion detection that are arranged at different positions.

Furthermore, the invention also includes the concept of realizing a combination of the measures mentioned above. This can be done e.g. in such a way that firstly the presence of corrosion at all is ascertained (but still without specific location information) by way of the non-contact inductive conductivity measurement and then a spatially resolved corrosion detection is obtained on the basis of a magnetoinductive flow measurement by ascertaining zonal variations of the flow velocity with the aid of detectors or sensors, respectively, that are arranged at suitable positions (in particular corrosion-critical locations such as cooling liquid diverting points and flange connections).

In this case, the invention also includes the principle, in particular, of ascertaining incipient corrosion not just by analysing the cooling liquid at an external apparatus (such as e.g. in the region where coolant is processed), but by means of a suitable measurement at suitable positions in the region of the element itself that is to be cooled.

In accordance with one embodiment, the optical element is a mirror or a mirror array comprising a plurality of mirror elements.

In accordance with one embodiment, the optical element is designed for an operating wavelength of less than 30 nm, in particular less than 15 nm. However, the invention is not limited thereto, and so the invention can also be realized advantageously in further applications in an optical system having an operating wavelength in the VUV range (for example of less than 200 nm or less than 160 nm).

The invention further relates to an optical system of a microlithographic projection exposure apparatus, in particular an illumination device or a projection lens, comprising at least one assembly having the features described above.

The invention further also relates to a method for operating an optical system, in particular of a microlithographic projection exposure apparatus, wherein the optical system has an assembly comprising at least one optical element and at least one cooling channel through which can flow a cooling fluid for cooling said optical element during the operation of the optical system, wherein the method comprises the following steps:

a) detecting an existing or imminent corrosion on the basis of the determination of at least one measurement variable indicating a corrosion-dictated change in state of the cooling fluid; and

b) carrying out, in reaction to the detection of an existing or imminent corrosion, a countermeasure for avoiding corrosion-dictated damage to the optical system by the cooling fluid.

Carrying out the countermeasure can comprise, in particular, at least one of the following steps:

- exchanging a component of the optical system;

- sealing the cooling channel; and

- setting or interrupting cooling operation of the optical system.

In accordance with one embodiment, the assembly is configured in accordance with the features described above.

Further configurations of the invention can be gathered from the description and the dependent claims.

The invention is explained in greater detail below on the basis of exemplary embodiments illustrated in the accompanying figures.

BRIEF DESCRIPTION OF THE DRAWINGS

In the figures:

Figure 1     shows a schematic illustration for elucidating the construction of an assembly in accordance with one embodiment of the invention;

Figure 2     shows a diagram for elucidating a possible evaluation of measurement results obtained in the assembly from Figure 1;

Figure 3     shows a schematic illustration for elucidating the construction of an assembly in accordance with a further embodiment of the invention; and

Figure 4     shows a schematic illustration for elucidating the possible construction of a microlithographic projection exposure apparatus designed for operation in the EUV.

DETAILED DESCRIPTION OF PREFERRED EMBODIMENTS

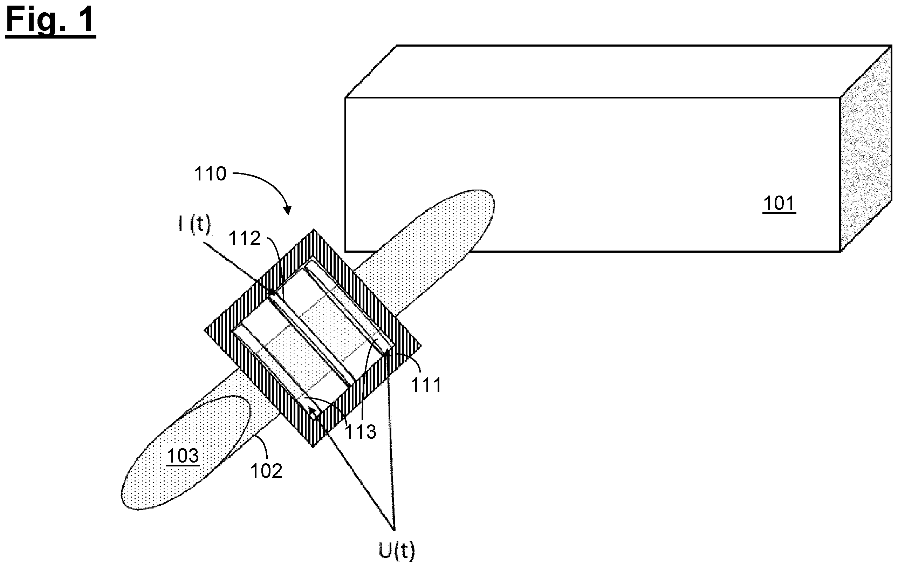

Possible embodiments of an assembly according to the invention are described below with reference to the schematic illustrations of Figs. 1-3.

In Fig. 1, "101" denotes a structure to be cooled in the assembly according to the invention. Said structure to be cooled can have e.g. a heat sink serving as a carrier for at least one optical element (not illustrated), within which heat sink there is provided a cooling channel through which a cooling fluid 103 such as e.g. water flows during operation. Said cooling channel has an inlet and an outlet for the cooling fluid 103 and is connected to a corresponding cooling fluid source for realizing a closed cooling circuit. "102" denotes a cooling line connected to the at least one cooling channel.

The heat sink can be produced from any suitable material having good thermal conduction such as e.g. steel, aluminium or copper. A component forming the cooling channel can be produced from the same or another suitable material, in principle.

The optical element can be - without the invention being restricted thereto - a mirror or a mirror array (in particular a facet mirror) of a microlithographic projection exposure apparatus designed for operation in the EUV. However, the invention is also advantageously usable, in principle, in any other applications (including outside lithography) in which the intention is to realize effective dissipation of heat while avoiding the corrosion-dictated problems described in the introduction.

What the embodiments described below have in common is that during the operation of the assembly or of the optical system having the assembly, an existing or imminent corrosion is detected on the basis of the determination of at least one measurement variable indicating a corrosion-dictated change in state of the cooling fluid 103. For this purpose, the assembly according to the invention has at least one corrosion detector, which can be configured in various ways depending on the type of measurement variable used as indicative of the existing or imminent corrosion.

In accordance with the exemplary embodiment in Fig. 1, a corrosion detector designated by "110" in the region of the coolant feed or the cooling line 102 connected to the at least one cooling channel has a transmitter coil 112 and receiver coils 113 in a housing 111 in order to establish an impedance measuring system. The impedance measuring system provided by the corrosion detector 110 in accordance with Fig. 1 makes it possible to detect the ionization state or the electrical conductivity of the cooling fluid 103 metrologically by means of a comparison between the transmission voltage generated by the transmitter coil 112 (or the electric current I(t) flowing through the transmitter coil 112) and the receiver voltage occurring at the receiver coils 113.

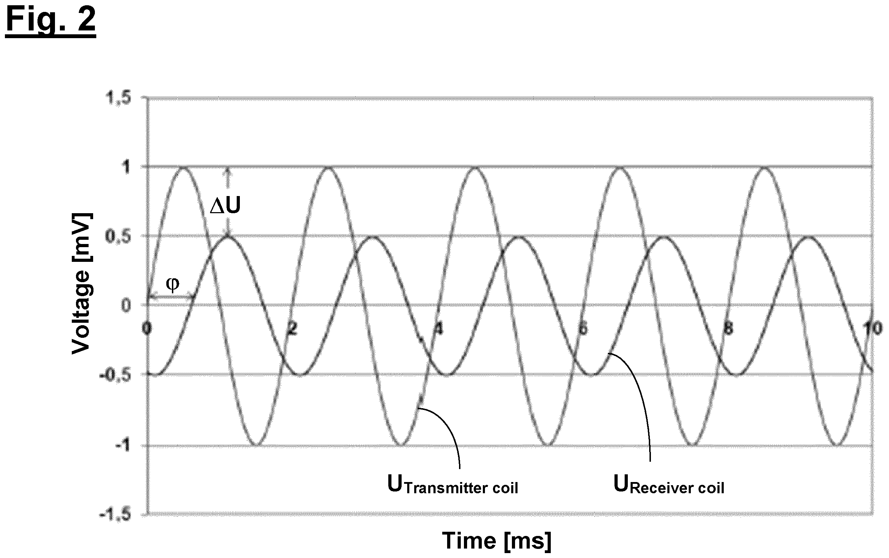

Fig. 2 shows an exemplary diagram of time-dependent voltage profiles, the amplitude attenuation and phase shift measurable between transmission voltage and receiver voltage being used as an indicator of the electrical conductivity and thus the (corrosion) state of the cooling liquid.

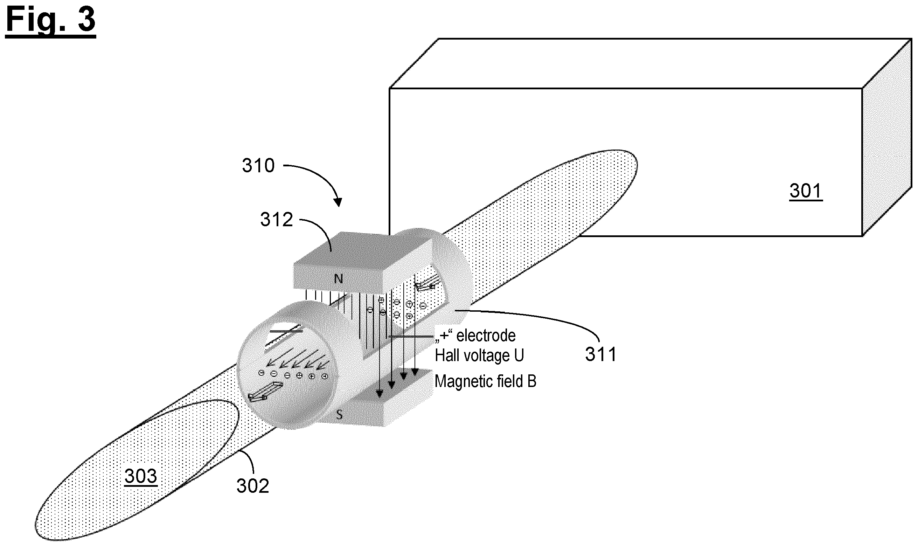

Fig. 3 shows, in a schematic illustration, a further possible construction of an assembly according to the invention, wherein analogous or substantially functionally identical components in comparison with Fig. 1 are designated by reference numerals increased by "200". In accordance with Fig. 3, in contrast to Fig. 1, a magnetoinductive flow measurement on the basis of the Hall effect is carried out. In this case, by means of a magnet arrangement 312, a homogenous magnetic field is applied to an insulated pipe 311 surrounding the cooling line 302, wherein the electrical voltage proportional to the strength of the magnetic field and the flow velocity is measured. The flow velocity of the cooling fluid 303 can thus be deduced from this measured electrical voltage. The following holds true here:

$$U = B \cdot d \cdot v \qquad (1)$$

where $U$ denotes the electrical voltage, $B$ denotes the magnetic field, $d$ denotes the distance between electrodes (i.e. the diameter of the insulated pipe 311) and v denotes the velocity of the ions (that is to say the flow velocity of the cooling fluid 303).

In further embodiments, it is possible - in addition or as an alternative to the determination of the measurement variables described with reference to Fig. 1 and Fig. 3, respectively, for the use of corresponding corrosion detectors - also to determine further measurement variables indicating a corrosion-dictated change in state of the cooling fluid. By way of example, sound excitations caused by corrosion-induced turbulence and other flow characteristics of the cooling fluid can also be detected by corresponding acoustic detectors. In further embodiments, additionally or alternatively, a permanent or sampling-like chemical analysis of the cooling fluid with regard to the presence of indicator molecules or particles dissolved from a material of the assembly in the event of corrosion (e.g. iron ions) can also be carried out in an automated manner.

In accordance with a further aspect of the invention, the corrosion detection according to the invention can also be effected in a spatially resolved manner, by virtue of corresponding corrosion detectors being arranged e.g. at positions that are particularly critical with regard to corrosion, such as e.g. flange connections. In this case, according to the invention, for example, in a first (non-spatially resolved) step by way of a conductivity measurement in accordance with Fig. 1 the existence or imminence of corrosion at all can be determined, whereupon the exact position within the assembly at which the relevant corrosion has occurred or is imminent is determined in a second, spatially resolved step (e.g. by determining a zonal variation of the flow velocity) with a set-up in accordance with Fig. 3.

In practice, a simulation model or mathematical model can be stored in the cooler design, which model is used to calculate, on the basis of CFD simulations (CFD= "Computed Fluid Dynamics"), the flow changes or turbulence caused by corrosion at significant locations equipped with sensors or corrosion detectors. This model can be verified with test subjects, such that measurement data can be compared with the expected values.

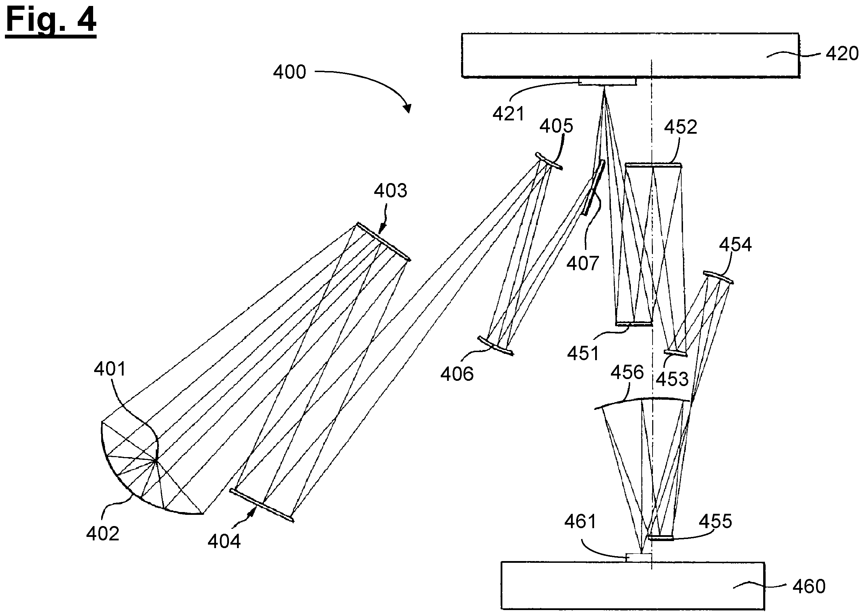

Fig. 4 shows a schematic illustration of an exemplary projection exposure apparatus which is designed for operation in the EUV and in which the present invention can be realized by way of example.

According to Fig. 4, an illumination device in a projection exposure apparatus 400 designed for EUV comprises a field facet mirror 403 and a pupil facet mirror 404. The light from a light source unit comprising a plasma light source 401 and a collector mirror 402 is directed onto the field facet mirror 403. A first telescope mirror 405 and a second telescope mirror 406 are arranged in the light path downstream of the pupil facet mirror 404. A deflection mirror 407 is arranged downstream in the light path, said deflection mirror directing the radiation that is incident thereon onto an object field in the object plane of a projection lens comprising in this case e.g. six mirrors 451-456. At the location of the object field, a reflective structure-bearing mask 421 is arranged on a mask stage 420, said mask being imaged with the aid of the projection lens into an image plane in which a substrate 461 coated with a light-sensitive layer (photoresist) is situated on a wafer stage 460.

The assembly according to the invention can serve for cooling any desired optical element of the projection exposure apparatus 400, for example a mirror or facet mirror within the illumination device or else one of the mirrors of the projection lens.

Even though the invention has been described on the basis of specific embodiments, numerous variations and alternative embodiments will be apparent to the person skilled in the art, for example through combination and/or exchange of features of individual embodiments. Accordingly, it goes without saying for the person skilled in the art that such variations and alternative embodiments are also encompassed by the present invention, and the scope of the invention is restricted only within the meaning of the appended patent claims.

## Claims

1. Assembly in an optical system, in particular of a microlithographic projection exposure apparatus, comprising:

   • at least one optical element;
   • at least one cooling channel through which can flow a cooling fluid (103, 303) for cooling said optical element during the operation of the optical system; **characterized in that** the assembly further comprises
   • at least one corrosion detector (110, 310) for detecting an existing or imminent corrosion on the basis of the determination of at least one measurement variable indicating a corrosion-dictated change in state of the cooling fluid (103, 303).

2. Assembly according to Claim 1, **characterized in that** the at least one measurement variable comprises an electrical conductivity of the cooling fluid (103, 303).

3. Assembly according to Claim 1 or 2, **characterized in that** the corrosion detector (110) is configured for detecting an existing or imminent corrosion on the basis of a non-contact inductive conductivity measurement of the cooling fluid (103).

4. Assembly according to any of Claims 1 to 3, **characterized in that** the at least one measurement variable comprises a flow velocity of the cooling fluid (103, 303).

5. Assembly according to any of the preceding claims, **characterized in that** the corrosion detector (310) is configured for detecting an existing or imminent corrosion on the basis of a magnetoinductive flow measurement.

6. Assembly according to any of the preceding claims, **characterized in that** the at least one measurement variable comprises a flow resistance of the cooling fluid (103, 303).

7. Assembly according to any of the preceding claims, **characterized in that** the at least one measurement variable comprises dynamic excitations or vibrations that are caused by a corrosion-dictated change in the flow state of the cooling fluid (103, 303).

8. Assembly according to any of the preceding claims, **characterized in that** the at least one measurement variable comprises a proportion of indicator molecules or particles present in the cooling fluid (103, 303), wherein a presence of said indicator molecules or particles in the cooling fluid (103, 303) indicates that they have been dissolved from a material of the assembly in a corrosion-dictated manner.

9. Assembly according to any of the preceding claims, **characterized in that** it has a plurality of corrosion detectors (110, 310) for spatially resolved corrosion detection that are arranged at different positions of the assembly.

10. Assembly according to any of the preceding claims, **characterized in that** the optical element is a mirror or a mirror array comprising a plurality of mirror elements.

11. Assembly according to any of the preceding claims, **characterized in that** the optical element is designed for an operating wavelength of less than 30 nm, in particular less than 15 nm.

12. Optical system of a microlithographic projection exposure apparatus, in particular illumination device or projection lens, comprising at least one assembly according to any of Claims 1 to 11.

13. Method for operating an optical system, in particular of a microlithographic projection exposure apparatus, wherein the optical system has an assembly comprising at least one optical element and at least one cooling channel through which can flow a cooling fluid (103, 303) for cooling said optical element during the operation of the optical system, wherein the method comprises the following steps:

   a) detecting an existing or imminent corrosion on the basis of the determination of at least one measurement variable indicating a corrosion-dictated change in state of the cooling fluid; and
   b) carrying out, in reaction to the detection of an existing or imminent corrosion, a countermeasure for avoiding corrosion-dictated damage to the optical system by the cooling fluid.

14. Method according to Claim 13, **characterized in that** carrying out the countermeasure comprises at least one of the following steps:

   - exchanging a component of the optical system;
   - sealing the cooling channel; and
   - setting or interrupting cooling operation of the optical system.

15. Method according to Claim 13 or 14, **characterized in that** the assembly is configured according to any of Claims 1 to 11.

**Patentansprüche**

1. Anordnung in einem optischen System, insbesondere einem mikrolithografischen Projektionsbelichtungsgerät, umfassend:

   • mindestens ein optisches Element;
   • mindestens einen Kühlkanal, durch den ein Kühlfluid (103, 303) fließen kann, um das optische Element während des Betriebs des optischen Systems zu kühlen;

   **dadurch gekennzeichnet, dass** die Anordnung des Weiteren umfasst:

   • mindestens einen Korrosionsdetektor (110, 310) zum Detektieren einer vorhandenen oder drohenden Korrosion basierend auf der Bestimmung von mindestens einer Messvariablen, die eine korrosionsdiktierte Änderung des Zustands des Kühlfluids (103, 303) angibt.

2. Anordnung nach Anspruch 1, **dadurch gekennzeichnet, dass** die mindestens eine Messvariable eine elektrische Leitfähigkeit des Kühlfluids (103, 303) umfasst.

3. Anordnung nach Anspruch 1 oder 2, **dadurch gekennzeichnet, dass** der Korrosionsdetektor (110) ausgestaltet ist, um eine vorhandene oder drohende Korrosion basierend auf einer kontaktlosen induktiven Leitfähigkeitsmessung des Kühlfluids (103) zu detektieren.

4. Anordnung nach einem der Ansprüche 1 bis 3, **dadurch gekennzeichnet, dass** die mindestens eine Messvariable eine Flussgeschwindigkeit des Kühlfluids (103, 303) umfasst.

5. Anordnung nach einem der vorhergehenden Ansprüche, **dadurch gekennzeichnet, dass** der Korrosionsdetektor (310) ausgestaltet ist, um eine vorhandene oder drohende Korrosion basierend auf einer magnetoinduktiven Flussmessung zu detektieren.

6. Anordnung nach einem der vorhergehenden Ansprüche, **dadurch gekennzeichnet, dass** die mindestens eine Messvariable einen Durchflusswiderstand des Kühlfluids (103, 303) umfasst.

7. Anordnung nach einem der vorhergehenden Ansprüche, **dadurch gekennzeichnet, dass** die mindestens eine Messvariable dynamische Erregungen oder Vibrationen umfasst, die durch eine korrosionsdiktierte Änderung in dem Flusszustand des Kühlfluids (103, 303) bewirkt werden.

8. Anordnung nach einem der vorhergehenden Ansprüche, **dadurch gekennzeichnet, dass** die mindestens eine Messvariable eine Proportion von Indikatormolekülen oder - partikeln umfasst, die in dem Kühlfluid (103, 303) vorhanden sind, wobei eine Anwesenheit der Indikatormoleküle oder -partikel in dem Kühlfluid (103, 303) angibt, dass sie von einem Material der Anordnung in einer korrosionsdiktierten Weise gelöst worden sind.

9. Anordnung nach einem der vorhergehenden Ansprüche, **dadurch gekennzeichnet, dass** sie eine Vielzahl von Korrosionsdetektoren (110, 310) für räumlich aufgelöste Korrosionsdetektierung aufweist, welche an unterschiedlichen Positionen der Anordnung angeordnet sind.

10. Anordnung nach einem der vorhergehenden Ansprüche, **dadurch gekennzeichnet, dass** das optische Element ein Spiegel oder eine Spiegelgruppierung, die eine Vielzahl von Spiegelelementen umfasst, ist.

11. Anordnung nach einem der vorhergehenden Ansprüche, **dadurch gekennzeichnet, dass** das optische Element für eine Arbeitswellenlänge von weniger als 30 nm, insbesondere weniger als 15 nm konzipiert ist.

12. Optisches System für ein mikrolithografisches Projektionsbelichtungsgerät, insbesondere Beleuchtungsvorrichtung oder Projektionslinse, umfassend mindestens eine Anordnung nach einem der Ansprüche 1 bis 11.

13. Verfahren zum Betreiben eines optischen Systems, insbesondere eines mikrolithografischen Projektionsbelichtungsgeräts, wobei das optische System eine Anordnung aufweist, die mindestens ein optisches Element und mindestens einen Kühlkanal umfasst, durch den ein Kühlfluid (103, 303) fließen kann, um das optische Element während des Betriebs des optischen Systems zu kühlen, wobei das Verfahren die folgenden Schritte umfasst:

a) Detektieren einer vorhandenen oder drohenden Korrosion basierend auf der Bestimmung von mindestens einer Messvariablen, die eine korrosionsdiktierte Änderung des Zustands des Kühlfluids angibt; und
b) Durchführen einer Gegenmaßnahme zum Vermeiden von korrosionsdiktiertem Schaden an dem optischen System durch das Kühlfluid in Reaktion auf die Detektierung einer vorhandenen oder drohenden Korrosion.

14. Verfahren nach Anspruch 13, **dadurch gekennzeichnet, dass** Durchführen der Gegenmaßnahme mindestens einen der folgenden Schritte umfasst:

- Auswechseln einer Komponente des optischen Systems;
- Versiegeln des Kühlkanals; und
- Einrichten oder Unterbrechen des Kühlbetriebs des optischen Systems.

15. Verfahren nach Anspruch 13 oder 14, **dadurch gekennzeichnet, dass** die Anordnung nach einem der Ansprüche 1 bis 11 ausgestaltet ist.

**Revendications**

1. Ensemble dans un système optique, en particulier d'un appareil d'exposition par projection microlithographique, comprenant :

• au moins un élément optique ;
• au moins un canal de refroidissement à travers lequel peut s'écouler un fluide de refroidissement (103, 303) pour refroidir ledit élément optique pendant le fonctionnement du système optique ; **caractérisé en ce que** l'ensemble comprend en outre
• au moins un détecteur de corrosion (110, 310) pour détecter une corrosion existante ou imminente sur la base de la détermination d'au moins une variable de mesure indiquant un changement dicté par la corrosion dans l'état du fluide de refroidissement (103, 303).

2. Ensemble selon la revendication 1, **caractérisé en ce que** l'au moins une variable de mesure comprend une conductivité électrique du fluide de refroidissement (103, 303).

3. Ensemble selon la revendication 1 ou 2, **caractérisé en ce que** le détecteur de corrosion (110) est configuré pour détecter une corrosion existante ou imminente sur la base d'une mesure de conductivité inductive sans contact du fluide de refroidissement (103) .

4. Ensemble selon l'une quelconque des revendications 1 à 3, **caractérisé en ce que** l'au moins une variable de mesure comprend une vitesse d'écoulement du fluide de refroidissement (103, 303).

5. Ensemble selon l'une quelconque des revendications précédentes, **caractérisé en ce que** le détecteur de corrosion (310) est configuré pour détecter une corrosion existante ou imminente sur la base d'une mesure d'écoulement magnéto-inductive.

6. Ensemble selon l'une quelconque des revendications précédentes, **caractérisé en ce que** l'au moins une variable de mesure comprend une résistance à l'écoulement du fluide de refroidissement (103, 303).

7. Ensemble selon l'une quelconque des revendications précédentes, **caractérisé en ce que** l'au moins une variable de mesure comprend des excitations ou vibrations dynamiques qui sont provoquées par un changement dicté par la corrosion dans l'état d'écoulement du fluide de refroidissement (103, 303).

8. Ensemble selon l'une quelconque des revendications précédentes, **caractérisé en ce que** l'au moins une variable de mesure comprend une proportion de molécules ou particules indicatrices présentes dans le fluide de refroidissement (103, 303), dans lequel une présence desdites molécules ou particules indicatrices dans le fluide de refroidissement (103, 303) indique qu'elles ont été dissoutes à partir d'un matériau de l'ensemble d'une manière dictée par la corrosion.

9. Ensemble selon l'une quelconque des revendications précédentes, **caractérisé en ce qu'**il a une pluralité de détecteurs de corrosion (110, 310) pour une détection de la corrosion résolue spatialement qui sont disposés à différentes positions de l'ensemble.

10. Ensemble selon l'une quelconque des revendications précédentes, **caractérisé en ce que** l'élément optique est un miroir ou un réseau de miroirs comprenant une pluralité d'éléments miroirs.

11. Ensemble selon l'une quelconque des revendications précédentes, **caractérisé en ce que** l'élément optique est conçu pour une longueur d'onde de fonctionnement de moins de 30 nm, en particulier moins de 15 nm.

12. Système optique d'un appareil d'exposition par projection microlithographique, en particulier dispositif d'éclairage ou lentille de projection, comprenant au moins un ensemble selon l'une quelconque des revendications 1 à 11.

13. Procédé de fonctionnement d'un système optique, en particulier d'un appareil d'exposition par projection microlithographique, le système optique ayant un ensemble comprenant au moins un élément optique et au moins un canal de refroidissement à travers lequel peut s'écouler un fluide de refroidissement (103, 303) pour refroidir ledit élément optique pendant le fonctionnement du système optique, le procédé comprenant les étapes suivantes :

   a) détection d'une corrosion existante ou imminente sur la base de la détermination d'au moins une variable de mesure indiquant un changement dicté par la corrosion dans l'état du fluide de refroidissement ; et
   b) réalisation, en réaction à la détection d'une corrosion existante ou imminente, d'une contre-mesure pour éviter un endommagement dicté par la corrosion du système optique par le fluide de refroidissement.

14. Procédé selon la revendication 13, **caractérisé en ce que** la réalisation de la contre-mesure comprend au moins une des étapes suivantes :

   - échange d'un composant du système optique ;
   - scellement du canal de refroidissement ; et
   - réglage ou interruption de l'opération de refroidissement du système optique.

15. Procédé selon la revendication 13 ou 14, **caractérisé en ce que** l'ensemble est configuré selon l'une quelconque des revendications 1 à 11.

Fig. 1

EP 4 049 088 B1

## Fig. 2

Fig. 3

**Fig. 4**

EP 4 049 088 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102017221388 A1
- JP 4718267 B
- US 20160274045 A1
- US 20080163692 A1